# EUROPÄISCHE PATENTSCHRIFT

(11) **EP 1 499 490 B1**
(45) Veröffentlichungstag und Bekanntmachung des Hinweises auf die Patenterteilung: **16.04.2014**
(21) Anmeldenummer: 02785242.5
(22) Anmeldetag: 18.10.2002
(51) Int. Cl.: B29C 67/00, G03F 7/00, C08J 3/28

(54) **VERFAHREN ZUM ERZEUGEN DREIDIMENSIONALER KÖRPER ODER OBERFLÄCHEN DURCH LASER-BESTRAHLUNG**
METHOD FOR PRODUCING THREE-DIMENSIONAL BODIES OR THREE-DIMENSIONAL SURFACES BY LASER RADIATION
PROCEDE POUR CREER DES CORPS TRIDIMENSIONNELS OU DES SURFACES TRIDIMENSIONNELLES PAR RAYONNEMENT LASER

(30) Priorität: 26.10.2001 DE 10152878
(43) Veröffentlichungstag der Anmeldung: 26.01.2005
(73) Patentinhaber: Fraunhofer-Gesellschaft zur Förderung der angewandten Forschung e.V., 80686 München (DE); LASER ZENTRUM HANNOVER e.V., D-30419 Hannover (DE)
(72) Erfinder: HOUBERTZ-KRAUSS, Ruth, 97440 Werneck (DE); SCHULZ, Jochen, 97209 Veitshöchheim (DE); FROEHLICH, Lothar, 97072 Würzburg (DE); POPALL, Michael, 97072 Würzburg (DE); CHICHKOV, Boris, 30173 Hannover (DE); SERBIN, Jesper, 30916 Isernhagen (DE)
(74) Vertreter: Olgemöller, Luitgard Maria
(86) Internationale Anmeldenummer: PCT/EP2002/011690
(87) Internationale Veröffentlichungsnummer: WO 2003/037606

(56) Entgegenhaltungen:
- DE-A- 4 126 759
- US-A- 5 461 088
- US-A- 5 639 413
- US-A- 5 734 000
- DATABASE WPI Derwent Publications Ltd., London, GB; AN 1990-263642 XP002233931 & JP 02 111530 A (OSAKA), 24. April 1990 (1990-04-24)
- DATABASE WPI Derwent Publications Ltd., London, GB; AN 1997-346173 XP002233932 & JP 09 141748 A (TAKEMOTO)

## Beschreibung

Die Erfindung betrifft die Erzeugung beliebiger Körper mit dreidimensionalen Strukturen, die entweder freitragend und/oder durch einen Träger gehalten sein können, durch Verfestigen einer polymerisierbaren Flüssigkeit. Diese Körper sind für vielerlei Zwecke, insbesondere jedoch für optische, (di)elektrische, magnetische und mechanische Anwendungen, z.B. als dreidimensionale, substratgestützte Schichten oder als freitragende, dreidimensionale und bezüglich ihrer Größe und Form völlig frei wählbare Körper, geeignet. Insbesondere können Strukturen oder Körper in Größenordnungen bis unterhalb des µm-Bereichs generiert werden.

Zur Herstellung dreidimensionaler Körper aus polymerisierbaren Flüssigkeiten hat man in der Vergangenheit vor allem stereolithographische Verfahren eingesetzt. So sei auf die beiden WO-Schriften 93/08506 und 95/25003 verwiesen, die eine durch Strahlungseinwirkung verfestigbare Flüssigkeit beschreiben, die durch schichtweise (Stereo)Lithographie zu einem dreidimensionalen Körper verfestigt wird. Der schichtweise Aufbau der Formkörpers erfolgt bei diesem Verfahren dadurch, daß man eine Trägerplatte oder Bauplattform zunächst dicht unterhalb der Badoberfläche anordnet und die über der Trägerplatte liegende Schicht der Flüssigkeit nach Maßgabe des gewünschten Querschnitts des Objektes bestrahlt, um so eine Basisschicht des Objekts zu verfestigen, die auf der Trägerplatte aufliegt. Sodann wird die Trägerplatte mit der darauf verfestigten Schicht weiter in das Bad hinein bewegt, wobei sich eine nachfolgend zu verfestigende Flüssigkeitsschicht über die bereits verfestigte Schicht legt. Der sorgfältigen Schichtpräparation kommt bei diesem Verfahren besondere Bedeutung zu. So ist es mittlerweile gängige Praxis, nach jedem Absenken der zuletzt verfestigten Schicht ein Abstreifelement einer relativ aufwendigen Einrichtung zur Glättung der flüssigen Schicht über die Badoberfläche zu ziehen. Das Auftragen und Glätten der neuen Flüssigkeitsschicht benötigt in etwa den gleichen Zeitraum wie das Belichten der Flüssigkeitsoberfläche bei der Verfestigung. Da der Prozess der jeweiligen Präparation einer neuen Flüssigkeitsschicht an der Badoberfläche über der zuletzt verfestigten Schicht nicht mehr nennenswert beschleunigt werden kann, ist dieses Verfahren durch die dafür aufzuwendende Zeit in seiner praktischen Anwendung limitiert. Außerdem ist die erreichbare Formteilgenauigkeit durch die Abstreifglättungstechnik beschränkt. Dies liegt unter anderem daran, daß die beim Glätten der Flüssigkeitsoberfläche entstehenden Scherkräfte eine große Belastung für z.B. dünnwandige Formteile darstellen. Außerdem müssen die zum Glätten benutzten Abstreifelemente oder Wischerklingen individuell an die jeweiligen Eigenschaften der Flüssigkeit, z.B. an die Viskosität, angepaßt werden. Dementsprechend ist es sehr mühsam, mit diesem Verfahren dreidimensionale Körper herzustellen.

Die Entwicklung von Strukturen/Komponenten/Bauelementen im Bereich der Sensorik, der Mikrotechnik, der Daten- und Telekommunikation, der Elektronik, der Chiptechnologie und der Medizintechnik tendiert zu immer kleiner werdenden Strukturen bei gleichzeitiger Erhöhung der Integrationsdichte sowie auch ihrer Funktionalität. Das setzt zum einen geeignete Materialien voraus, zum anderen werden auch flexible Methoden benötigt, welche die herausragenden Materialeigenschaften dann auch in ihrer vollen Bandbreite zur Entfaltung bringen können.

Eine relativ neue Technik zur Erzeugung dreidimensionaler Strukturen erfolgt mit Hilfe der sogenannten Zwei-Photonen-Absorptions-Photopolymerisation. Damit läßt sich mit relativ guter Genauigkeit ein nur kleiner Raum innerhalb der zu verfestigenden Flüssigkeit ansteuern, der durch die eingetragene Energie verfestigt wird. Die Herstellung des Formkörpers kann daher innerhalb einer entsprechenden Flüssigkeit erfolgen, nicht mehr (nur) an deren Oberfläche. Das genannte Verfahren ist beispielsweise in H.-B. Sun, et al., Opt. Lett. 25, 1110 (2000) und H.-B. Sun et al., Appl. Phys. Lett. 74, 786 (1999) beschrieben. Allerdings sind die üblichen einer solchen Polymerisation zugänglichen organischen Substanzen hierfür per se nicht geeignet. Zwei Strategien wurden beschrieben, um diesen Nachteil zu beseitigen: Einmal die Entwicklung spezieller Moleküle mit geeigneten Absorptionseigenschaften, wie bis-(diphenylamino)-substituierte Polyene, die nur unter großem Kostenaufwand erhältlich sind. Zum anderen die Verwendung von üblichen polymerisierbaren Materialien, die ultrakurzen Laserpulsen mit hoher Spitzenenergie ausgesetzt werden, z.B. Ti:Saphir-Femtosekundenlaser-Pulsen. Diese wurden mit Wellenlängen im Bereich von etwa 400 nm in die zu verfestigenden Harze eingestrahlt. Nicht nur die Diffusion von entstehenden Oligomeren verfälscht und verändert die Größe der verfestigten Volumenelemente (sog. Voxel). Die Pulsenergie und das Licht-Intensitäts-Profil spielen ebenfalls eine Rolle. Eine gute Reproduzierbarkeit ist daher nur schwer herstellbar; die Körper haben sehr ungenaue und insbesondere auch sehr rauhe Umrisse.

Kürzlich wurde ein verfeinertes Verfahren zur Herstellung von Formkörpern beim DPMA angemeldet (DE 101 11 422.2). Mit diesem ist ein direktes Polymerisieren eines photosensitiven Harzes ortsselektiv innerhalb des Badvolumens, also auch ggf. weit unterhalb der Badoberfläche, mit hoher Genauigkeit möglich. Gemäß diesem Verfahren wird Strahlung aus einem Spektralbereich verwendet, der normalerweise nicht von der photosensitiven Flüssigkeit unter Hervorrufung des Verfestigungseffektes absorbiert wird. Bei nicht zu hohen Strahlungsintensitäten ist die Flüssigkeit somit für die verwendete Strahlung im Wesentlichen transparent. Das zu verfestigende Bad wird mit Strahlung bestrahlt, deren Wellenlänge λ in etwa n x λₒ beträgt, wobei λₒ die Wellenlänge bezeichnet, bei der das flüssige Material Strahlung absorbieren würde und der Absorptionsvorgang mit einer optischen Anregung unter Auslösung des Materialverfestigungsprozesses einherginge. n ist eine ganze Zahl größer als 1. In der Praxis ist n üblicherweise 2. Erzeugt man nun durch Intensitätskonzentration der Strahlung innerhalb des Flüssigkeitsbades eine intensitätserhöhung, bei der Mehrphotonenabsorption, nämlich n-Photonenabsorption (vorwiegend mit n gleich 2 , aber auch z.B. 3) stattfindet, so kann in dem Bereich dieser lokal erhöhten Intensität die energetische Anregung des Materials zur Induzierung des Verfestigungseffektes durch Bestrahlung mit Licht der Wellenlänge λ erfolgen, wobei diese Strahlung außerhalb der genannten Zone erhöhter Strahlungsintensität die Flüssigkeit in der bereits genannten Weise durchdringt, ohne den Verfestigungseffekt auszulösen. Die Zone erhöhter Intensität kann dabei mit relativ einfachen Mitteln dadurch realisiert werden, daß man den Strahl, ggf. nach vorausgegangener Strahlaufweitung, fokussiert, so daß nur in unmittelbarer Umgebung des Fokus die Intensität hoch genug ist, um Zweiphotonenabsoprtion (n = 2) oder Mehrphotonenabsorption (n = 3, ...) in dem flüssigen Material zu erreichen. Zur Herstellung eines Formkörpers in dem Bad kann dann der Fokus nach Maßgabe von Geometriebeschreibungsdaten des Formkörpers innerhalb des Badvolumens zu den zu verfestigenden Stellen gerührt werden. Ein ähnliches Verfahren wurde jüngst von Kawata et al. in einer Kurzmitteilung in Nature, Vol 412, S. 697 vorgestellt.

Im Gegensatz zu den stereolithographischen Verfahren, welche eine Gegenstand schichtweise in einem Bad einer durch Strahlungseinwirkung verfestigbaren Flüssigkeit unter Bewegung des Objektes weiter in das Bad hinein verfestigen, wird bei der Erzeugung mittels Femtosekundenlaser-Bestrahlung ein zu erzeugender dreidimensionaler Körper also in nur einem Arbeitsschritt auf einer Oberfläche oder im Volumen produziert. Dies führt dazu, dass keine unerwünschten Gradienteneffekte im Bauteil auftreten, die bei stereolithographischen Verfahren durch die Art und Weise der Herstellung von Formkörpern durchaus auftreten können. Es können jedoch durch die Variation von z.B. der eingestrahlten Leistungsdichte gezielt Gradienten generiert werden, was zur Ausbildung dichter oder weniger dichter Netzwerke führt.

Allerdings sind die für diese Verfahren eingesetzten Materialien in der Regel organische Thermoplaste (z.B. Polymethylmethacrylat), die teilweise schon bei Temperaturen ab 80°C erweichen oder schmelzen. Diese sind daher bereits aus diesem Grund für eine Vielzahl von Anwendungen, insbesondere in den oben erwähnten Bereichen der Sensorik, der Mikrotechnik, der Telekommunikation, der Elektronik, der Chiptechnologie und der Medizintechnik, nicht geeignet.

Eine Vielzahl von Organopolysiloxanen (auch als organisch modifizierte Kieselsäurepolykondensate, anorganisch-organische Hybridpolymere oder Silanharze bezeichnet) zeigt bei Belichtung mit UV-Licht (Wellenlängenbereich bis 400 nm) Negativ-Resist-Verhalten. Man kann sie dementsprechend für (stereo-)lithographische Verfahren einsetzen, siehe beispielsweise US 5,639,413, JP-Abstract 02 111 530 A oder JP-Abstract 09 141 748. Die Auflösung bei konventionellen Verfahren, wie z.B. optischer Lithographie, schwankt je nach verwendetem Organopolysiloxan und liegt meist zwischen 5 bis 10 µm (R. Houbertz et al., Mater. Res. Soc. Symp., im Druck; B. Arkles, MRS Bulletin 26(5), 402 (2001)). Werden die Materialien hingegen durch Prägen strukturiert, lassen sich Strukturen im Bereich einiger 100 nm generieren, siehe I. Anke et al., SPIE 2783, 325 (1996); H. Fan et al., Mater. Res. Soc. Symp. 628, CC6.33.1 (2000); M.A. Clarner et al., a.a.O. 628, CC9.3.1 (2000). Darüber hinaus wurde für die Strukturierung von organisch-anorganischen Materialien auch ein Interferenzverfahren verwendet, welches zwar lateral eine Auflösung im 200 nm-Bereich hat, vertikal jedoch aufgrund des Verfahrens versagt (P.W. Oliveira et al., Production of fresnel lenses in sol-gel derived Ormocers by holography, SPIEproceedings 2288, 554 (1994)). Alle üblicherweise für die Strukturierung von Organopolysiloxanen verwendeten Verfahren haben den entscheidenden Nachteil, dass sie keine hochaufgelöste Strukturierung unter Einhaltung der Kantensteilheit bei gleichzeitig befriedigend hohem Aspektverhältnis gestatten.

Der vorliegenden Erfindung liegt die Aufgabe zugrunde, ein Verfahren bereitzustellen, mittels dessen mit Hilfe von Zwei- (oder Mehr-)Photonen-Polymerisation in einem Bad einer verfestigbaren Substanz beliebige dreidimensionale Strukturen, sei es in Form von (ggf. selbsttragenden) Körpern, sei es in Form von oberflächenstrukturierten oder sonstigen Schichten, die ggf. von einem Substrat gehalten werden, erzeugt werden können, und zwar mit verbesserter Formgenauigkeit der dreidimensionalen Strukturen, insbesondere der Möglichkeit eines extrem hohen Aspektverhältnisses und mit einer deutlich verringerten Oberflächenrauhigkeit, was ihre Anwendung insbesondere im Bereich der Optik attraktiv macht. Diese Körper oder Schichten sollen auch extrem klein sein oder extrem geringdimensionierte Strukturen tragen können. Sie sollen sich insbesondere als Komponenten für optische, (di)elektrische, magnetische, mechanische, biologische/biochemische und medizinische Anwendungen eignen.

Die genannte Aufgabe wird dadurch gelöst, daß das Bad der zu verfestigbaren Substanz ganz, zu überwiegenden oder zu bedeutenden Anteilen aus Polysiloxanen (organisch modifizierten Kieselsäurepolykondensaten) besteht, die organische, einer Zwei- oder Mehrphotonenpolymerisation zugängliche Gruppen enthalten.

Überraschend konnte gefunden werden, daß die Bestrahlung und damit einhergehende Polymerisation/Verfestigung solcher Substanzen (die in der Regel in einer flüssigen bis pastösen Form vorliegen, die als Harz oder Lack bezeichnet wird), zu Körpern oder Schichten führt, die nach dem Aushärten als Duroplaste eine meist deutlich höhere Temperaturstabilität und höhere Flexibilität in den Anwendungsbereichen und der Applikatioristechnologie mit sich bringen als Körper oder Schichten aus rein organischen Verbindungen. Auch sonstige physikalische und chemische Eigenschaften der auf diese Weise generierten Körper oder Schichten sind ausgezeichnet. Die Körper, Schichten oder deren Strukturen können dabei bis in den sub-µm-Bereich generiert werden.

Die Herstellung von organisch modifizierten Polysiloxanen oder Kieselsäurekondensaten (häufig auch als "Silanharze" bezeichnet) und deren Eigenschaften ist in einer Fülle von Publikationen beschrieben worden. Stellvertretend sei hier z.B. auf Hybrid Organic-Inorganic Materials, MRS Bulletin 26(5), 364ff (2001) verwiesen. Ganz allgemein werden solche Substanzen in der Regel mit Hilfe des sogenannten Sol-Gel-Verfahrens hergestellt, indem hydrolyseempfindliche, monomere oder präkondensierte Silane, ggf. in Gegenwart weiterer cokondensierbarer Substanzen wie Alkoxiden des Bor, Germanium oder Titan, sowie ggf. von zusätzlichen Verbindungen, die als Modifikatoren oder Netzwerkwandler dienen können, oder von sonstigen Additiven wie Füllstoffen, einer Hydrolyse und Kondensation unterworfen werden.

Erfindungsgemäß ist dementsprechend jede Flüssigkeit einsetzbar; die ein Organopolysiloxan-Material enthält, das beispielsweise durch Hydrolyse und mindestens teilweise Kondensation mindestens eines Silans der Formel (I)

R¹ₐR²_{b}SiX_{4-a-b} (I)

erhalten wurde, worin R¹ gleich oder verschieden ist und einen organischer, über Zwei- oder Mehrphotonenpolymerisation polymerisierbarer Rest darstellt. Dabei ist es bevorzugt, daß die Zwei- oder Mehrphotonenpolymerisation über eine bzw. mehrere Gruppen erfolgt, die sich radikalisch polymerisieren lassen. Zwar sind auch solche Systeme erfindungsgemäß geeignet, die sich mit Hilfe eines kationischen UV-Starters polymerisieren lassen, beispielsweise Epoxysysteme (siehe z.B. C.G. Roffey,

Photogeneration of Reactive Species for UV Curing, John Wiley & Sons Ltd, (1997)). Doch neigen diese Systeme zu parasitärer Polymerisation, d.h. es findet auch eine Polymerisation in die nicht belichteten Bereiche hinein statt, weswegen sie für Anwendungsbereiche mit extremen Anforderungen an die Feinheit und Glätte der Oberflächen, z.B. hochaufgelöste Lithographie, weniger gut geeignet sind. R² in Formel (I) kann gleich oder verschieden sein und bedeutet einen organischen Rest, der sich nicht durch 2-Photonenpolymerisation an andere Gruppen addieren läßt. Die Gruppe X in Formel (I) ist ein unter Hydrolysebedingungen vom Silicium abhydrolysierbarer Rest. Der Index a bedeutet 1, 2 oder 3, der Index b bedeutet 0, 1 oder 2, und a+b sollen zusammen 1, 2 oder 3 sein.

Bevorzugt enthält der Rest R¹ in Formel (I) eine nichtaromatische C=C-Doppelbindung, besonders bevorzugt eine einer Michael-Addition zugängliche Doppelbindung. R² kann eine ggf. substituierte Alkyl-, Aryl-, Alkylaryl- oder Arylalkylgruppe sein, wobei die Kohlenstoffkette dieser Reste ggf. durch O, S, NH, CONH, COO, NHCOO oder dgl. unterbrochen sein kann. R² kann dabei auch Gruppen enthalten, die mit C=C Doppelbindungen eine Additionsreaktion eingehen können. Die Gruppe X ist in der Regel Wasserstoff, Halogen, Alkoxy, Acyloxy oder NR³₂ mit R³ gleich Wasserstoff oder Niederalkyl. Alkoxygruppen sind als abhydrolysierbare Gruppen bevorzugt, insbesondere Niederalkoxygruppen wie C₁-C₆-Alkoxy.

Das verfestigbare Organopolysiloxan kann unter Verwendung mindestens eines weiteren Silans der Formel (II)

- SiX₄ (II)

erzeugt worden sein, worin X gleich oder verschieden ist und die gleiche Bedeutung wie in Formel (I) besitzt. Eine hierfür gut einsetzbare Verbindung ist Tetraethoxysilan. Durch Zugabe solcher Silane zu der zu hydrolysierenden und kondensierenden Mischung, aus der schließlich das polymerisierbare Badmaterial entsteht, wird der SiO-Antell des Harzes, also der anorganische Anteil, erhöht. Dadurch läßt sich die Absorption des Harzes in den interessierenden Wellenlängen senken.

Umgekehrt kann das erfindungsgemäß organisch zu polymerisierende Silanpolykondensat unter Verwendung mindestens eines Silans mit der Formel (IV)

R¹ₐSiR²₄₋ₐ (IV)

hergestellt worden sein, worin R₁ und R₂ die in Anspruch 1 für Formel (I) angegebene Bedeutung haben. Dadurch wird der Vernetzungsgrad des Polykondensates heruntergesetzt.

Die Mischung, aus der das Silankondensat erzeugt wird, kann weiterhin mindestens ein Silanol der Formel (III)

R⁴ₐSi(OH)₄₋ₐ (III)

enthalten, worin R⁴ gleich oder verschieden sein kann und jeweils entweder die Bedeutung von R¹ wie in Formel (I) definiert oder von R² wie in Formel (I) definiert besitzt und worin der Index a 1, 2 oder 3, vorzugsweise 2 bedeutet. Silanole werden ohne Wasserbildung in das anorganische Netzwerk einkondensiert. Die Hydrolyse kann in Gegenwart dieser Verbindungen daher mit von Katalytisch wirksamen Mengen von Wasser erfolgen; im übrigen kann das System wasserfrei bleiben. In einer bevorzugten Ausgestaltung der Erfindung werden Disilanole der Formel (III) im Mischungsverhältnis von 1:1 (Mol/Mol) mit Silanen der Formel (I), die vorzugsweise eine Gruppe R¹ enthalten, als zu hydrolysierendes und kondensierendes Ausgangsmaterial eingesetzt.

Wenn R¹ in Formel (I) eine C=C-Doppelbindung trägt und R² in dieser Formel nicht vorhanden ist oder keine funktionellen Gruppen besitzt, kann in einer spezifischen Ausgestaltung dem zu hydrolysierenden und kondensierenden Material mindestens ein Silan der Formel (V)

R²ₐSiX₄₋ₐ (V)

zugegeben werden, worin R² eine Gruppe trägt, die radikalisch an eine C=C-Doppelbindung addiert werden kann. Entsprechende Kondensate sind dann einer Polymerisation durch Additionsreaktionen der Gruppen R² der Silane der Formel (V) an Doppelbindungen der Reste R¹ der Silane mit der Formel (I) zugänglich.

Die für die Zwecke der vorliegenden Erfindung zu hydrolysierende und kondensierende Mischung kann weitere Substanzen enthalten, z.B. vorzugsweise niedere Alkoxide, insbesondere C₁-C₆-Alkoxide, von Metallen der III. Hauptgruppe, von Germanium und von Metallen der II., III., IV., V., VI., VII. und VIII. Nebengruppe.

Insgesamt sollte das organisch modifizierte Kieselsäurepolykondensat, aus dem erfindungsgemäß durch Zwei- oder Mehrphotonenpolymerisation Körper verfestigt werden können, vorzugsweise mindestens 0,1 Mol an einer Zweiphotonenpolymerisation zugänglichen Gruppen (R¹ der Formel (I)) aufweisen, bezogen auf die Molmenge an Siliciumatomen plus ggf., soweit vorhanden, der Metallatome der III. Hauptgruppe, von Germanium und der II., III., IV., V., VI., VII. und VIII. Nebengruppe.

Insbesondere lassen sich erfindungsgemäß siliciumbasierte Harze/Lacke einsetzen, wie sie in der WO 93/25604 oder der DE 199 32 629 A1 beschrieben sind. Darunter bevorzugt sind die modifizierten Kieselsäurepolykondensate der DE 199 32 629 A1, da diese unter Verwendung von Silandiolen hergestellt sind, wodurch eine Kondensation ohne Bildung von Wasser erfolgt. Ganz besonders bevorzugt sind Co-Kondensationsprodukte der Verbindungen Ar₂Si(OH)₂ und R¹Si(OR')₃, worin Ar ein aromatischer Rest mit 6 bis 20 Kohlenstoffen, insbesondere ggf. substituiertes Aryl und ganz besonders bevorzugt ein direkt an das Silicium gebundener, unsubstituierter Phenylrest ist und R¹ die für Formen (I) angegebene Bedeutung besitzt und vorzugsweise mindestens eine Epoxygruppe oder eine C=C-Doppelbindung, insbesondere eine einer Michaeladdition zugängliche Doppelbindung, aufweist (z.B. eine (Meth-)Acrylatgruppe ist). Ganz besonders bevorzugt ist R¹ in dieser Kombination eine Methacryloxyalkyl, z.B. eine Methacryloxypropylgruppe. Die Herstellung eines Silankondensates aus einer Mischung von Diphenylsilandiol und 3-Methacryloxypropyltrimethoxysilan im Molverhältnis 1:1 ist in der genannten DE 199 32 629 A1 in Beispiel 1 beschrieben.

In einer bevorzugten Ausgestaltung der Erfindung wird die Flüssigkeit des Bads mittels Bestrahlung mit Femtosekunden-Laserpulsen verfestigt. Als hierfür geeignete Laser lassen sich vorzugsweise Ti-Saphir-Laser einsetzen (entweder mit der fundamentalen Wellenlänge von 780 nm oder, je nach Absorptionsverhalten der zu erhärtenden Flüssigkeit, mit der zweiten Harmonischen bei 390 nm); auch andere NIR-Laser (z.B. mit emittierten Wellenlängen von 800 nm bis etwa 1500 nm) sind geeignet. Aber auch andere Laserbestrahlung ist möglich, sofern die eingesetzte Lichtquelle mit einer Intensität in das Bad einstrahlen kann, die für eine Mehrphotonenanregung ausreichend bzw. geeignet ist. Diese Eigenschaft bieten bei moderaten mittleren Leistungen insbesondere Kurzpulslaser. Das auszuhärtende Material muß transparent für die verwendete Laserwellenlänge sein. Wenn das zu verfestigende Material beispielsweise bei 390 nm einer Einphotonen-Polymerisation zugänglich wäre, kann jede Wellenlänge von 400 nm oder darüber für die Zwei- oder ' Mehrphotonenpolymerisation eingesetzt werden; je nach Harz sind wegen der Transparenzbedingungen vor allem 500-1000 nm geeignet. Bei Verwendung größerer Wellenlängen kann die Polymerisation auch durch eine n-Photonenabsorption initialisiert werden, wobei n größer 2 gilt. Die Schwellen-Fluenz, bei welche der Polymerisationsprozess startet, kann durch die Wahl geeigneter Komponenten, wie z.B. Co-Initiatoren und/oder Aminkomponenten mit einem erhöhten Mehrphotonen-Absorptionsquerschnitt.im Harz gesenkt werden. Dadurch wird das Prozessfenster, in dem die Polymerisation stattfindet, das Material jedoch noch nicht zerstört wird, vergrößert.

Insbesondere bei Einsatz von Femtosekundenlasern als Strahlungsquelle erhält man Körper/Schichten mit einer drastisch erhöhten lithographischen Auflösung ohne unerwünschte Nebeneffekte der Strukturierung, wie beispielsweise Kantenverrundung, Inhibierung oder geringer lithographischer Auflösung. Dabei kann auf die herkömmliche, teilweise aufwendige Präparation von Schichten, welche üblicherweise zur Strukturierung verwendet wird, verzichtet werden. Die Erzeugung echter, formgenauer dreidimensionaler Strukturen und Komponenten für optische, (di)elektrische, magnetische, mechanische, biochemische und medizinische Anwendungen wird dadurch erheblich präziser, schneller und zuverlässiger. Art und Dauer der Bestrahlung liefern darüber hinaus die Möglichkeit, den Vernetzungsgrad gezielt zu variieren, so dass mit ein und demselben Material bei Bedarf unterschiedliche physikalische Eigenschaften (z.B. Brechzahl) erzielt werden können. Im Unterschied zur dreidimensionalen Strukturierung durch Prägen können mit diesem Verfahren nicht nur dreidimensionale Strukturen auf Substraten (Trägermaterialien) gefertigt werden, sondern es können dreidimensionale freitragende Körper vollständig aus dem Volumen heraus gefertigt werden.

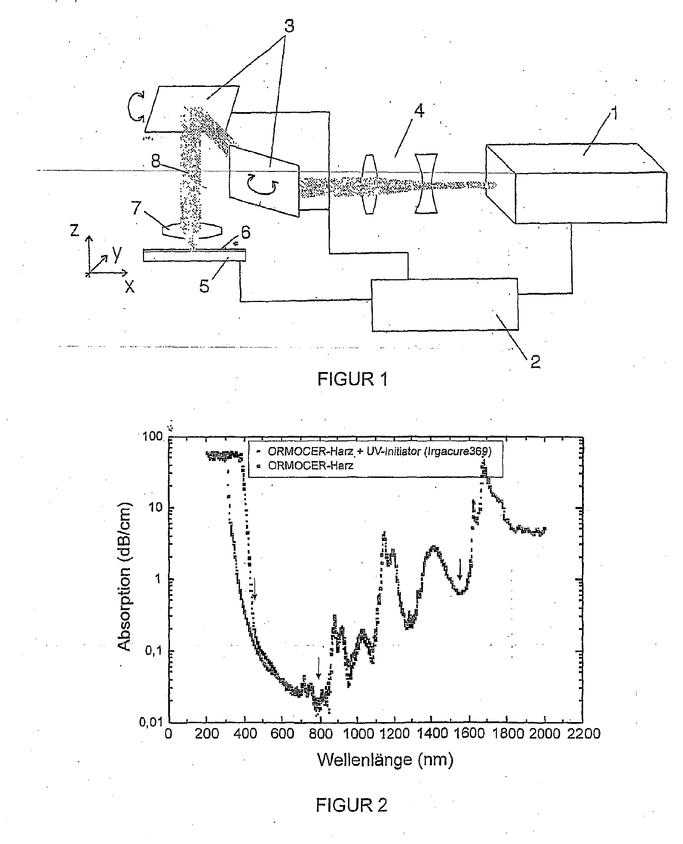

**Figur 1** zeigt beispielhaft eine Anordnung zur Erzeugung dreidimensionaler Strukturen: Als Strahlquelle (1) dient ein Laser, z.B. ein gepulster Laser für die Erzeugung ultrakurzer Laserpulse (Pulsdauer 10 ps bis 10 fs). Um die Qualität des Laserfokus zu kontrollieren, können strahlformende Optiken (4) zum Einsatz kommen (z.B. eine Strahlaufweitung für einen kleinstmöglichen Fokusdurchmesser). Zwei computergesteuerte, rotierende Spiegel (3) werden eingesetzt, um den Laserstrahl in definierter Weise in x- und y-Richtung abzulenken. Der Laserstrahl (8) wird mit Hilfe einer fokussierenden Optik (7) in das zu polymerisierende Harz (5) fokussiert. Bei dieser Optik handelt es sich um eine einzelne Linse oder um Linsensysteme, z.B. Mikroskop-Optiken. Das zu polymerisierende Harz befindet sich unter oder auf einem transparentem Substrat (6). Das Harz kann entweder durch das transparente Substrat (6) bestrahlt werden (siehe Skizze), das in diesem Falle eine hohe optische Oberflächengüte aufweisen sollte, oder es kann sich auf der Oberseite des Substrates befinden und direkt bestrahlt werden (ohne Abbildung). Das Substrat mit dem Harz kann mit Hilfe von computergesteuerten Positioniersystemen in x-, y- und z-Richtung in definierter Weise bewegt werden. Dies, zusammen mit den rasternden Spiegeln, ermöglicht es, den Laserfokus in drei Dimensionen durch das Harz bzw. das Harz durch den Fokus zu bewegen. Alternativ kann die fokussierende Optik (7) in z-Richtung bewegt werden, um den Fokus in z-Richtung durch das Harz zu bewegen. Die Komponenten Laser (1), Scanner (3), sowie alle Positioniereinheiten werden von einem PC (2) gesteuert und kontrolliert.

Das erfindungsgemäße Verfahren ist für jede beliebige physikalische Anwendung geeignet, insbesondere eignet es sich für die bereits oben erwähnten Anwendungen. Beispiele für Gegenstände, die erfindungsgemäß gefertigt werden können, sind Schwingungsaufnehmer, mikromechanische bzw. mikroelektromechanische Teile oder Gegenstände, die in der optischen Nachrichtentechnik benötigt werden. Das Verfahren eignet sich aber auch für den Einsatz beim *Rapid-Prototyping* und für die Herstellung neuartiger optischer Komponenten.

Ein herausragendes Charakteristikum der erfindungsgemäß einsetzbaren Organopolysiloxane ist, dass extrem variable physikalische, chemische und/oder biologische Eigenschaften durch *chemical design* generiert werden können, wobei auch mehrere Eigenschaften vereint, wie z.B. sehr gute optische (Brechzahltuning, geringe optische Verluste) und sehr gute dielektrische Eigenschaften (variable Permittivität, geringe dielektrische Verluste, hohe Durchschlagsfestigkeit auch im Bereich dünner Schichten), auftreten können. Diese Eigenschaften sind im Stand der Technik bereits ausführlich diskutiert worden; neben den beiden oben erwähnten Druckschriften sei in diesem Zusammenhang auf C. Roscher et al., Mater. Res. Soc. Symp. 519, 239 (1998), M. Popall et al., aaO. 264, 353 (1992); G.R. Atkins et al., "Optical Devices for Fiber Communication II", M.J.F. Digonnet et al (eds.), Proc. SPIE Vol 4216 (2001) und U. Streppel et al., "Multilayer optical fan-out device composed of stacked monomode waveguides", SPIE (2001) verwiesen.

Wie oben schon erwähnt, sind organisch durch Zwei-Photonenpolymerisation vernetzte Organopolysiloxane duroplastische Materialien, die sich durch eine gute Temperaturbeständigkeit sowie eine hervorragende Temperatur-Formbeständigkeit im Vergleich zu den meisten rein organischen Polymeren auszeichnen. Gegebenenfalls kann ein Teil oder der gesamte organische Anteil nach der organischen Vernetzung gezielt aus den Materialien eliminiert werden, z.B. durch eine Pyrolyse bei ca. 300-1200°C, wobei ein silikatisches (anorganisches) SiO₂-Netzwerk bestehen bleibt. Dies läßt sich z.B. gezielt bei der Herstellung von Fasern für die Gasseparation nutzen. Außerdem sind vernetzte Organopolysiloxane für die Verwendung im Bereich der Dentalmedizin geeignet, da sie, soviel man bisher weiß, als nicht toxisch einzustufen sind, im Gegensatz zu z.B. typischen rein organischen Methacrylate (siehe z.B. DE 41 33 494 C2 oder H. Wolter, a.a.O.). Dass sie nicht toxisch sind, ist durch ihren Aufbau begründet, der vorwiegend aus Oligomeren besteht. Rein organische Monomere können sie nicht enthalten. Sie haben sich dementsprechend auch bereits ein hohes Anwenderpotential in der Medizintechnik erworben.

Eine Reihe von erfindungsgemäß verwendbaren anorganisch vernetzbaren Organopolysiloxanen (Organokieselsäurepolykondensaten) besitzen eine niedrige Absorption im Bereich der für Daten- und Telekommunikation interessierenden Wellenlängen (810 bis 1550 nm). Solche Polymere erhält man beispielsweise, wenn das Kondensat nur noch unbedeutende Anteile an SiOH-Gruppen aufweist oder fast oder ganz frei davon ist. **Figur 2** zeigt ein nach dem erfindungsgemäßen Verfahren vernetztes Polykondensat aus Diphenylsilandiol und 3-Methacryloxypropyltrimethoxysilan, (zur Erkennung der Absorptionsbanden des UV-Starters Irgacure 369 in der Mischung einmal mit und einmal ohne diesen Starter dargestellt). Eine niedrige Absorption erhält man auch z.B. durch Einsatz von Ausgangsmaterialien, deren kohlenstoffhaltige Gruppen ganz oder teilweise fluoriert sind. Weiterhin ist es für diesen Zweck z.B. günstig, den Anteil an SiO-Gruppen im Harz, also den "anorganischen" Anteil, relativ hoch zu halten. Dies gelingt beispielsweise durch Zusatz von Silanen zu der zu hydrolysierenden Mischung, die keine organischen Gruppen enthalten, sondern an allen vier Resten hydrolysiert werden können, z.B. von Tetraalkoxysilanen wie Tetraethoxysilan. Die im Bereich von 810 bis 1550 nm wenig lichtabsorbierenden Materialien erlauben es, mit Hilfe des erfindungsgemäßen Verfahrens passive und aktive optische Elemente mit hoher Oberflächenqualität kostengünstig zu fertigen.

Ein besonderer Vorteil des im Rahmen der vorliegenden Erfindung aufgefundenen Verfahrens ist es, dass dreidimensionale Körper mit einer enormen Flankensteilheit, einem hohen Aspektverhältnis und einer sehr guten Auflösung erzeugt werden können, so dass beliebige dreidimensionale Strukturen, sei es in Form von (ggf. selbsttragenden) Körpern, sei es in Form von oberflächenstrukturierten oder sonstigen Schichten, die ggf. von einem Substrat gehalten werden, generiert werden können. Das bedeutet, dass auch Hinterschnitte oder Hohlräume realisiert werden können. In der herkömmlichen Stereolithographie sind solche Formkörper zwar, wie erwähnt, ebenfalls realisierbar; das schichtweise Auftragen des Harzes sowie das Glätten der Harzoberfläche mit einem Wischer, wie es in der Stereolithographie üblich ist, bringt aber Nachteile mit sich, die bei dem erfindungsgemäßen Verfahren wegfallen: Zum einen ist das Auftragen und Glätten einer neuen Harzschicht sehr zeitaufwendig (etwa 50 % der gesamten Prozessdauer). Zum anderen treten beim Glätten der Herzoberfläche Scherkräfte auf, welche das Bauteil belasten und somit die Strukturgrößen limitieren.

Die Begrenzung der lithographischen Auflösung bei Verwendung optischer Lithographie wird dabei nicht durch das Material selbst bestimmt (mit Ausnahme solcher Systeme, die möglicherweise einer parasitären Polymerisation unterliegen können, siehe oben), sondern durch die üblicherweise für die Strukturierung angewendeten Verfahren, wie z.B. Belichtung durch eine Maske unter *Proximity* Bedingungen; eine Kontaktbelichtung wäre lediglich unter Inkaufnahme einer Verschmutzung der verwendeten Masken aufgrund der sehr guten Haftung der Organopolysiloxane zu fast allen Materialien oder durch Verwendung teurer, speziell zu diesem Zweck beschichteter Masken möglich. Darüber hinaus gibt es bei der UV-Strukturierung von speziellen Organopolysiloxanen den Nachteil aller radikalisch polymerisierbaren Systeme, dass sich bei Anwesenheit von Sauerstoff und je nach verwendetem Photoinitiator eine Inhibierungsschicht in Oberflächennähe ausbildet, welche in diesen Bereichen die UV-Vernetzung des Materials behindert. Dies ist je nach verwendetem Heteropolysiloxan mehr oder weniger stark ausgeprägt, lässt sich jedoch bisher ohne besondere Vorkehrungen schwer vermeiden. Alternativ kann unter Ausschluss von Sauerstoff unter Stickstoffexposition belichtet werden, was einerseits hinsichtlich der Inhibierungsschicht zum Erfolg führt, andererseits jedoch an der Auflösungsbegrenzung (*Proximity*) nichts ändert sowie auch apparativ erheblich aufwendiger ist. Daher ist ein weiterer Vorteil der erfindungsgemäßen Strukturierung mit Hilfe von Organopolysiloxanen, dass die Körper und/oder Oberflächen Komponenten aus dem Volumen heraus, d.h. vollkommen unter Ausschluss von Luftsauerstoff bzw. nur noch bei Anwesenheit des im Harz/Lack gelösten Sauerstoffs und unter Verzicht einer Stickstoffspülung, strukturiert werden können.

Wie erwähnt, sind Harze auf Organopolysiloxanbasis Materialien, die in einer großen Vielzahl und Vielfalt in Hinblick auf verschiedene physikalische, chemische und biologische Eigenschaften ausgewählt werden können, da sie eine Vielzahl verschiedener funktioneller Gruppen tragen können, welche die physikalischen und chemischen Eigenschaften des Harzes beeinflussen (z.B. Netzwerkbildner, Netzwerkwandler). Daher sind diese Harze für eine Anwendung in den bezeichneten Gebieten von besonderem Vorteil. Vor allem die erfindungsgemäß bevorzugte Nutzung von Femtosekundenlaser-Bestrahlung von Silanharzen zur Strukturierung und Herstellung dreidimensionaler Strukturen, sei es in Form von (ggf. selbsttragenden) Körpern, sei es in Form von oberflächenstrukturierten oder sonstigen Schichten, die ggf. von einem Substrat gehalten werden, für optische, (di)elektrische, magnetische, mechanische, biochemische und medizinische Anwendungen ermöglicht es, die strukturellen Eigenschaften der Materialien mit hoher Auflösung zu nutzen. Grundlage des erfindungsgemäßen Polymerisationsprozesses ist, wie erwähnt, die Zwei-Photonen-Polymerisation, wobei die Erfinder die Feststellung machen konnten, dass der Wechselwirkungsquerschnitt (die Wahrscheinlichkeit der 2P-Absorption) der erfindungsgemäß einsetzbaren Organopolysiloxane hinreichend groß ist, um dieses Verfahren zur Erzeugung dreidimensionaler Strukturen, sei es in Form von (ggf. selbsttragenden) Körpern, sei es in Form von oberflächenstrukturierten oder sonstigen Schichten, die ggf. von einem Substrat gehalten werden, einzusetzen. Die Erfinder konnten mittels Femtosekundenlaser-Bestrahlung bereits eine lithographische Auflösung von ca. 100 nm erreichen. Allerdings sind diese Werte noch nicht optimiert. Es ist zu erwarten, daß aufgrund der kleinsten Strukturelemente der Heteropolysiloxan-Harze/Lacke im Bereich weniger nm (1 bis 5 nm) (siehe Popall et al., a.a.O.) bei Verbesserung der verfahrenstechnischen Anlagen eine erheblich bessere lithographische Auflösung erzielt werden kann. Die erfindungsgemäß bevorzugte organische Polymerisation von Organopolysiloxanen mit der Zwei-Rhotonen-Polymerisation sollte darüber hinaus die Möglichkeit bieten, eine Initialisierung des Polymerisationsprozesses ohne UV-Initiator durchführen zu können, welches im wesentlichen von der eingestrahlten Leistungsdichte (→ notwendige Temperaturen dafür im Bereich bis 200 °C, weit unter der typischen Temperaturstabilität bis 270 °C) abhängen sollte.

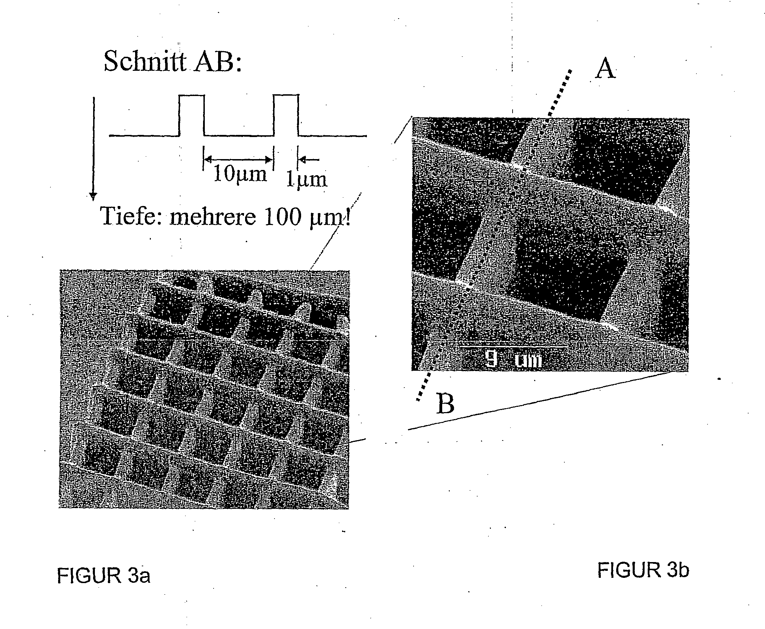

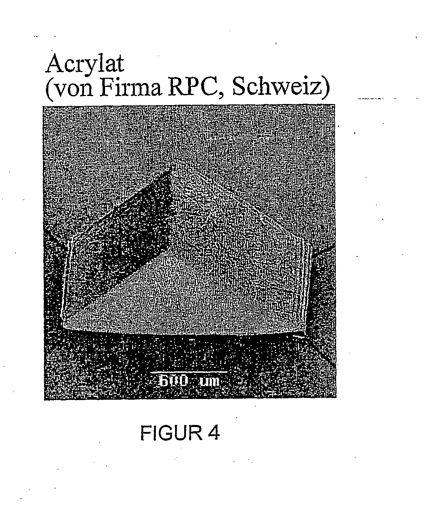

Die **Figuren 3a und 3b** zeigen eine für sensorische oder biomedizinische Anwendungen geeignete Wabenstruktur, wobei die gezeigte Stegbreite ca. 1 µm bei einer Kanallänge von mehreren 100 µm beträgt. Der Prozess lässt sich dabei durch Variation der Laserparameter, wie z.B. Pulsenergie und Pulsdauer, Fokussieroptik, sowie durch Verwendung verschiedener Organopolysiloxane mit ihren unterschiedlichen Funktionalitäten gezielt im Hinblick auf Auflösung und Anwendungsgebiet steuern. Besonders bemerkenswert ist das gezeigte, sehr hohe Aspektverhältnis von bis zu 500 und sogar noch darüber, das im Bereich der für LIGA (Lithographie-Galvanische Abformung) demonstrierten Aspektverhältnisse liegt bzw. diese noch übertrifft. Durch die sehr hohe Ortselektivität ergibt sich zwangsläufig eine enorme Flankensteilheit, welche mit keinem konventionellen Verfahren so erzeugt werden kann. **Figur 4** zeigt im Vergleich hierzu ein Acrylatpolymeres der Firma RPC AG (Rapid Prototyping Chemicals, Marly, Schweiz), das für Argon- bzw. UV-Laser mit λ = 351 bzw. 364 nm optimiert ist. Man erkennt, dass die Rauhigkeit ein Vielfaches im Vergleich zu den erfindungsgemäß hergestellten Wabenkörpern beträgt (der Formkörper ist um einen Faktor von etwa 60 schwächer vergrößert als der in den Figuren 2a, 2b gezeigte Formkörper).

Mit dem erfindungsgemäßen Verfahren können komplette passive optische Elemente, wie z.B. Streifenwellenleiter für Mono- und Multimode-Wellenleitung oder auch diffraktive optische Elemente (DOE) vollständig prozessiert werden. Dabei wird die Prozessierung in einem Bad des Materials, also aus dem Volumen heraus, vorgenommen. Die Herstellung echter dreidimensionaler, selbsttragender oder auf einem Substrat aufliegender Körper in einem Arbeitsschritt führt zu einer drastischen Reduktion von Prozessierungszeiten. Darüber hinaus bietet das Verfahren die Möglichkeit, den Polymerisationsprozess durch geeignete Wahl des Fokuspunktes zu initiieren, wobei die Polymerisation nur im Bereich des Fokuspunktes gestartet wird. Anders ausgedrückt: Die Polymerisationsreaktion wird photonisch initiiert und abgebrochen. Darüber hinaus bildet sich keine wie bei der konventionellen Strukturierung von Organopolysiloxanen störende Inhibierungsschicht aus.

Die Flexibilität des Verfahrens und der dafür eingesetzten Organopolysiloxane einerseits und ihre Nicht-Toxizität andererseits gestattet ebenfalls eine Anwendung im Bereich der Herstellung beliebig komplizierter, dreidimensionaler Strukturen aus einem virtuellen Modell am Computer. Dies findet insbesondere auch Anwendung im Bereich der Fertigung medizintechnischer Komponenten, wie z.B. Gehörknochen und auch andere Implantate. Letzteres kann noch dadurch ergänzt werden, dass entsprechende Optiken, wie z.B. diffraktive optische Elemente, in einem Schritt integriert werden.

### Beispiel 1

Aus Diphenylsilandiol und 3-Methacryloxypropyltrimethoxysilan im Molverhältnis 1:1 wurde in Gegenwart von Bariumhydroxidmonohydrat als Katalysator nach Anweisung des Beispiels 1 der DE 199 32 629 A1 ein organisch modifiziertes Kieselsäurepolykondensat-Harz hergestellt. Aus diesem wurde ein Bad bereitet, das mit der in Figur 1 dargestellten Anordnung bestrahlt wurde. Der resultierende Festkörper ist in den Figuren 3a und 3b gezeigt.

## Patentansprüche

1. Verfahren zum Erzeugen von dreidimensionalen selbsttragenden und/oder substratgestützten Formkörpern oder von Strukturen auf Oberflächen durch ortsselektives Verfestigen eines flüssigen bis pastösen, organisch modifizierten, polysiloxanhaltigen Materials innerhalb eines Bades aus diesem Material mit Hilfe von Zwei- oder Mehr-Photonen-Polymerisation, wobei das organisch modifizierte Polysiloxan durch Hydrolyse und mindestens teilweise Kondensation eines Ausgangsmaterials erhältlich ist, das mindestens ein Silan der Formel (I)
R¹ₐR²_{b}SiX_{4-a-b} (I)
worin R¹ gleich oder verschieden ist und einen organischen, über Zwei- oder Mehrphotonenpolymerisation polymerisierbaren Rest darstellt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, enthält oder im wesentlichen daraus besteht.

2. Verfahren nach Anspruch 1, worin R¹ ein eine nichtaromatische C=C-Doppelbindung, vorzugsweise eine einer Michaealaddition zugängliche Doppelbindung, enthaltender Rest ist und/oder worin R² ggf. substituiertes Alkyl, Aryl, Alkylaryl oder Arylalkyl ist, wobei die Kohlenstoffkette dieser Reste ggf. durch O, S, NH, COHN, COO, NHCOO unterbrochen sein kann, und/oder mindestens eine Gruppe enthält, die mit C=C-Doppelbindungen radikalisch eine Additionsreaktion eingehen kann und/oder worin X Wasserstoff, Halogen, Hydroxy, Alkoxy, Acyloxy oder NR³₂ mit R³ gleich Wasserstoff oder Niederalkyl ist.

3. Verfahren nach Anspruch 1 oder 2, **dadurch gekennzeichnet, dass** das Ausgangsmaterial weiterhin mindestens ein weiteres Silan der Formel (II)
SiX₄ (II)
worin X gleich oder verschieden ist und die gleiche Bedeutung wie in Formel (I) besitzt, enthält.

4. Verfahren nach einem der voranstehenden Ansprüche, **dadurch gekennzeichnet, dass** das Ausgangsmaterial weiterhin mindestens ein weiteres Silan der Formel (III)
R⁴ₐSi(OH)₄₋ₐ (III)
worin R⁴ gleich oder verschieden sein kann und entweder die Bedeutung von R¹ wie in Formel (I) definiert oder von R² wie in Formel (I) definiert besitzt und worin der Index a 1, 2 oder 3 bedeutet, enthält.

5. Verfahren nach Anspruch 4, worin R⁴ wie R² in Formel (I) definiert ist und/oder der Index a in Formel (III) 2 ist.

6. Verfahren nach Anspruch 5, **dadurch gekennzeichnet, dass** das Ausgangsmaterial mindestens ein Silan der Formel (I) wie in Anspruch 1 definiert und mindestens ein Silan der Formel (III) wie in Anspruch 4 definiert enthält, wobei das/die Silan(e) der Formel (I) und das/die Silan(e) der Formel (III) im Molverhältnis von 1:1 vorhanden sind.

7. Verfahren nach einem der voranstehenden Ansprüche, **dadurch gekennzeichnet, dass** das Ausgangsmaterial mindestens eine weitere Verbindung, ausgewählt unter den C₁-C₈-Alkoxiden der Metalle der III. Hauptgruppe, von Germanium und von Metallen der II., III., IV., V., VI., VII. und VIII. Nebengruppe, enthält.

8. Verfahren nach einem der voranstehenden Ansprüche, **dadurch gekennzeichnet, dass** das Ausgangsmaterial weiterhin mindestens ein Silan der Formel (IV)
R¹ₐSiR²₄₋ₐ (IV)
worin R1 und R2 die in Anspruch 1 für Formel (I) angegebene Bedeutung haben, enthält.

9. Verfahren nach einem der voranstehenden Ansprüche, worin R² in Formel (I) nicht vorhanden ist oder keine an eine Doppelbindung addierbare Gruppe trägt, **dadurch gekennzeichnet, daß** das Ausgangsmaterial mindestens ein weiteres Silan der Formel (V)
R²ₐSiX₄₋ₐ (V)
enthält, worin R² eine Gruppe trägt, die radikalisch an eine C=C-Doppelbindung addiert werden kann.

10. Verfahren nach einem der voranstehenden Ansprüche, **dadurch gekennzeichnet, dass** das Material mindestens 0,1 Mol einer Zweiphotonenpolymerisation zugänglichen Gruppe aufweist, bezogen auf die molare Menge an Siliciumatomen plus ggf. der Metallatome der III. Hauptgruppe, von Germanium und der II., III., IV., V., VI., VII. und VIII. Nebengruppe.

11. Verfahren nach einem der voranstehenden Ansprüche, **dadurch gekennzeichnet, dass** das zu verfestigende Material im Bad nach Maßgabe von Geometriebeschreibungsdaten des herzustellenden Formkörpers dadurch verfestigt wird, daß die Bestrahlungsbedingungen durch erhöhte Intensitätskonzentration der Strahlung erfüllt werden.

12. Verfahren nach Anspruch 11, **dadurch gekennzeichnet, dass** man mit einem fokussierten Laserstrahl (8) in das Bad (5) einstrahlt, wobei die Bestrahlungsbedingungen zur Verfestigung des flüssigen bis pastösen Materials nur in unmittelbarer Umgebung des Fokus erfüllt sind, und dass man den Fokus des Strahls nach Maßgabe der Geometriebeschreibungsdaten des herzustellenden Formkörpers innerhalb des Badvolumens zu den verfestigenden Stellen führt.

13. Verfahren nach einem der Ansprüche 11 oder 12, **dadurch gekennzeichnet, dass** das zu verfestigende Material im Bad mit einem Laser (1) bestrahlt wird, der Strahlungsspulse kleiner Pulsdauer und hoher Strahlungsleistung pro Puls emittiert, insbesondere mit einem Femtosekundenlaser.

14. Verfahren nach Anspruch 13, **dadurch gekennzeichnet, dass** der Femtosekundenlaser ein modengekoppelter Laser, insbesondere ein Titan-Saphlr-Laser Ist.

15. Verfahren nach einem der Ansprüche 12 bis 14, **dadurch gekennzeichnet, dass** man den Fokus des Laserstrahls gemäß einer oder mehrerer der folgenden Maßnahmen zu den zu verfestigenden Stellen innerhalb des Bades führt:
- optische Elemente (4) zur Fokussierung des Strahls werden relativ zum Bad (5) gesteuert bewegt;
- optische Strahlablenkelemente (3) zur Ablenkung des Strahls werden relativ zum Bad (5) gesteuert bewegt;
- ein das Bad beinhaltender Behälter wird relativ zum Strahlfokus gesteuert bewegt;
- eine innerhalb eines das Bad beinhaltenden Behälters vorhandene Bauplattform wird in dem Bad relativ zum Strahlfokus gesteuert bewegt.

16. Verfahren nach einem der voranstehenden Ansprüche, **dadurch gekennzeichnet, dass** die oder eine der Oberflächen des herzustellenden Formkörpers Strukturen in der Größenordnung von weniger als 10 µm, stärker bevorzugt von weniger als 1 µm und am meisten bevorzugt von weniger als 0,1 µm aufweisen soll.

17. Verfahren nach einem der Ansprüche 1 bis 16, **dadurch gekennzeichnet, dass** es ein Rapid-Prototyping-Verfahren ist.

18. Verfahren nach einem der Ansprüche 1 bis 16, **dadurch gekennzeichnet, dass** innerhalb des Formkörpers unterschiedliche Vernetzungsgrade erhalten werden, indem die Bestrahlung mit unterschiedlichen Intensitätsgradienten erfolgt, vorzugsweise durch Senken der Intensität und Aufweitung des Fokus'.

19. Verfahren nach einem der Ansprüche 1 bis 18, **dadurch gekennzeichnet, dass** es sich bei dem dreidimensionalen selbsttragenden und/oder substratgestützten Formkörper um eine optisch aktive oder passive Struktur, einen photonischen Kristall oder eine diffraktive Optik handelt.

20. Verfahren nach einem der Ansprüche 1 bis 18, **dadurch gekennzeichnet, dass** der dreidimensionale selbsttragende und/oder substratgestützte Formkörper ein dielektrischer Formkörper, Teil eines Bauelements unter Verwendung von Dielektrika oder Teil eines magnetischen Formkörpers ist.

21. Verfahren nach einem der Ansprüche 1 bis 18, **dadurch gekennzeichnet, dass** der dreidimensionale selbsttragende und/oder substratgestützte Formkörper die Form eines Biochips oder eines mikroelektro-mechanischen Systems (MEMS) oder eines optischen MEMS besitzt oder die Form eine Strukturelements eines Biochips oder eines MEMS oder eines optischen MEMS besitzt.

22. Verfahren nach einem der Ansprüche 1 bis 18, worin der dreidimensionale selbsttragende und/oder substratgestützte Formkörper die Gestalt einer lithographischen Maske oder einer Prägungsmaske besitzt.

23. Verfahren nach einem der Ansprüche 1 bis 18, **dadurch gekennzeichnet, dass** der dreidimensionale selbsttragende und/oder substratgestützte Formkörper die Gestalt eines medizinischen Implantats besitzt, insbesondere für den Bereich der Ohren oder des Herzens.

24. Verfahren nach Anspruch 23, **dadurch gekennzeichnet, dass** der Formkörper die Gestalt eines Gehörknochen-Implantats oder einer Herzklappe besitzt.

25. Verfahren nach einem der Ansprüche 1 bis 18, **dadurch gekennzeichnet, dass** der dreidimensionale selbsttragende und/oder substratgestützte Formkörper die Gestalt eines Mikrochipsensors, vorzugsweise eines Gassensors besitzt, wobei in das organisch modifizierte Polysiloxan bevorzugt N-H-Gruppen eingebaut sind.

26. Verfahren nach einem der Ansprüche 1 bis 18, **dadurch gekennzeichnet, dass** der dreidimensionale selbsttragende und/oder substratgestützte Formkörper oder die Oberflächenstruktur Waben oder Kanäle aufweist, wobei das Aspektverhältnis zwischen der Tiefe der Kanäle oder Waben und der Stegbreite zwischen den Kanälen oder Waben bis zu 500 beträgt.

## Claims

1. Process for the production of three-dimensional, self-supporting and/or substrate-supported formed pieces or of surface structures by means of a site-selective solidification of a liquid to pasty, organically modified polysiloxane-containing material within a bath of this material using two-photon or multi-photon polymerization, wherein the organically modified polysiloxane is obtainable by hydrolysis and at least partial condensation of a starting material which comprises or essentially consists of at least one silane of formula (I)
R¹ₐR²_{b}SiX_{4-a-b} (I)
wherein R¹ is identical or different and has the meaning of an organic radical, polymerizable by means of two-photon or multi-photon polymerization, R² is identical or different and has the meaning of an organic radical which cannot be polymerized by the said means, and X is a radical which can hydrolyze from silicon under hydrolytic conditions, index a is 1, 2 or 3, index b is 0, 1 or 2, and a+b together are 2 or 3.

2. Process according to claim 1, wherein R¹ is a radical containing a non-aromatic C=C double bond, preferably a double bond which is available for a Michael addition, and/or wherein R² is optionally substituted alkyl, aryl, alkylaryl or arylalkyl, wherein the carbon chain of these radicals is optionally interrupted by O, S, NH, COHN, COO, NHCOO and/or comprises at least one group which is able to undergo an addition reaction with C=C double bonds, and/or wherein X is hydrogen, halogen, hydroxy, alkoxy, acyloxy or NR³₂ with R³ being hydrogen or lower alkyl.

3. Process according to claim 1 or 2, **characterized in that** the starting material further comprises at least one silane of formula (II)
SiX₄ (II)
wherein X is identical or different and has the same meaning as in formula (I).

4. Process according to any of the preceding claims, **characterized in that** the starting material further comprises at least one silane of formula (III)
R⁴ₐSi(OH)₄₋ₐ (III)
wherein R⁴ can be identical or different and either has the meaning of R¹ as defined in formula (I) or of R² as defined in formula (I) and wherein index a is 1, 2 or 3.

5. Process according to claim 4, wherein R⁴ is defined as R² in formula (I) and/or index a in formula (III) is 2.

6. Process according to claim 5, **characterized in that** the starting material comprises at least one silane of formula (I) as defined in claim 1 and at least one silane of formula (III) as defined in claim 4, wherein the silane(s) of formula (I) and the silane(s) of formula (III) are present in a molar ratio of 1:1.

7. Process according to any of the preceding claims, **characterized in that** the starting material comprises at least one additional compound, selected under the C₁-C₈ alkoxides of the metals of the III. main group, of germanium und of the metals of the II., III., IV., V., VI., VII., and VIII. sub group.

8. Process according to any of the preceding claims, **characterized in that** the starting material comprises at least one silane of formula (IV)
R¹ₐSiR²₄₋ₐ (IV)
wherein R¹ und R² have the meaning as given in claim 1 for formula (I).

9. Process according to any of the preceding claims, wherein R² in formula (I) is not present or does not comprise a group which can be added to a double bond, **characterized in that** the starting material comprises at least one additional silane of formula (V)
R²ₐSiX₄₋ₐ (V)
wherein R² carries a group which can be added to a C=C double bond by a free-radical additive reaction.

10. Process according to any of the preceding claims, **characterized in that** the material includes at least 0.1 mol of a group which is available for a two photon polymerization, with reference to the molar amount of silicon atoms plus optionally the metal atoms of the III. main group, of germanium und of the metals of the II., III., IV., V., VI., VII., and VIII. sub group.

11. Process according to any of the preceding claims, **characterized in that** the material to be solidified in the bath is solidified in line with the geometry description data of the formed piece to be produced by fulfilling the conditions of irradiation via an increased concentration of irradiation.

12. Process according to claim 11, **characterized in that** irradiation into the bath (5) is performed with a focused laser beam (8), wherein the irradiation conditions for solidification of the liquid to pasty material are only fulfilled in the immediate environment of the focus, and **in that** the focus of the beam is directed to the areas to be solidified within the bath volume according to the geometry description data of the solid body to be produced.

13. Process according to any of claims 11 and 12, **characterized in that** the material to be solidified in the bath is irradiated with a laser (1) emitting irradiation pulses of low pulse length and high radiation power per pulse, especially with a femtosecond laser.

14. Process according to claim 13, **characterized in that** the femtosecond laser is a mode locked laser, especially a titan sapphire laser.

15. Process according to any of claims 12 to 14, **characterized in that** the focus of the laser beam is directed to the areas to be solidified within the bath according to one or more of the following measures:
- optical elements (4) for the setting of the beam focus are moved in a movement that is controlled relatively to the bath (5);
- optical beam deflecting elements (3) for deflecting the beam are moved in a movement that is controlled relatively to the bath (5);
- a vessel containing the bath is moved in a movement that is controlled relatively to the beam focus;
- a construction platform present within a vessel containing the bath is moved within the bath in a movement that is controlled relatively to the beam focus.

16. Process according to any of the preceding claims, **characterized in that** the or one of the surface(s) of the piece to be formed shall have structures in the order of magnitude of less than 10 µm, more preferred of less than 1 µm und most preferred of less than 0,1 µm.

17. Process according to any of claims 1 to 16, **characterized in that** it is a rapid prototyping process.

18. Process according to any of claims 1 to 16, **characterized in that** within the formed piece, different degrees of cross-linking are obtained by irradiation with different gradients of intensity, preferably by lowering the intensity and broadening of the focus.

19. Process according to any of claims 1 to 18, **characterized in that** the three-dimensional self-supporting and/or substrate-supported formed body is an optically active or passive structure, a photonic crystal or a diffractive lens construction.

20. Process according to any of claims 1 to 18, **characterized in that** the three-dimensional self-supporting and/or substrate-supported formed body is a dielectric formed body, part of a construction element using dielectrics or part of a magnetic formed body.

21. Process according to any of claims 1 to 18, **characterized in that** the three-dimensional self-supporting and/or substrate-supported formed body has the form of a biochip or of a microelectro-mechanical system (MEMS) or of an optical MEMS or has the form of a structural element of a biochip or of a MEMS or of an optical MEMS.

22. Process according to any of claims 1 to 18, wherein the three-dimensional self-supporting and/or substrate-supported formed body has the form of a lithographic mask or of an embossing mask.

23. Process according to any of claims 1 to 18, **characterized in that** the three-dimensional self-supporting and/or substrate-supported formed body has the shape of a medical implant, especially for the area of the ears or of the heart.

24. Process according to claim 23, **characterized in that** the formed body has the shape of an implant for the auditory ossicle or of a cardial valve.

25. Process according to any of claims 1 to 18, **characterized in that** the three-dimensional self-supporting and/or substrate-supported formed body has the form of a microchip sensor, preferred that of a gas sensor, wherein preferably N-H groups are incorporated into the organically modified polysiloxane.

26. Process according to any of claims 1 to 18, **characterized in that** the three-dimensional self-supporting and/or substrate-supported formed body or the surface structure comprises honeycombs or channels (conduits, ducts), wherein the aspect ratio between the depth of the channels (conduits, ducts) or the honeycombs and the width of the webs between the channels (conduits, ducts) or the honeycombs is up to 500.

## Revendications

1. Procédé pour créer des corps moulés tridimensionnels autoporteurs et/ou portés par un support ou pour créer des structures sur des surfaces par solidification localement sélective d'un matériau contenant du polysiloxane, ce matériau étant liquide à pâteux et organiquement modifié, à l'intérieur d'un bain de ce matériau par polymérisation à deux photons ou plus, dans lequel le polysiloxane organiquement modifié peut être obtenu par hydrolyse et condensation au moins partielle d'une matière première contenant ou étant essentiellement constituée d'au moins un silane de la formule (I)
R¹ₐR²_{b}SiX_{4-a-b} (I)
dans laquelle R¹ est identique ou différent et représente un groupe organique polymérisable par polymérisation à deux photons ou plus, R² est identique ou différent et signifie un groupe organique non polymérisable selon cette méthode, et X désigne un groupe pouvant être séparé du silicium par hydrolyse dans des conditions d'hydrolyse, l'indice a est 1, 2 ou 3, l'indice b est 0, 1 ou 2 et a+b ensemble valent 1, 2 ou 3.

2. Procédé selon la revendication 1, dans lequel R¹ est un groupe contenant une liaison double C=C non aromatique, de préférence une liaison double accessible à une addition de Michael et/ou dans lequel R² est un alkyle, aryle, alkylaryle ou arylalkyle éventuellement substitué, dans lequel la chaîne carbone de ces groupes peut éventuellement être interrompue par O, S, NH, COHN, COO, NHCOO, et/ou contient au moins un groupe qui peut participer de façon radicalaire à une réaction d'addition avec des liaisons doubles C=C, et/ou dans lequel X est un hydrogène, halogène, hydroxy, alcoxy, acyloxy ou NR³₂ avec R³ qui est un hydrogène ou un alkyle inférieur.

3. Procédé selon la revendication 1 ou 2, **caractérisé en ce que** la matière première contient en outre au moins un autre silane de la formule (II)
SiX₄ (II)
dans laquelle X est identique ou différent et a la même signification que dans la formule (I).

4. Procédé selon l'une quelconque des revendications précédentes, **caractérisé en ce que** la matière première contient en outre au moins un autre silane de la formule (III)
R⁴ₐSi(OH)₄₋ₐ (III)
dans laquelle R⁴ peut être identique ou différent et possède soit la signification de R¹ définie comme dans la formule (I) soit celle de R² définie comme dans la formule (I) et dans laquelle l'indice a vaut 1, 2 ou 3.

5. Procédé selon la revendication 4, dans lequel R⁴ est défini comme R² dans la formule (I) et/ou l'indice a dans la formule (III) est 2.

6. Procédé selon la revendication 5, **caractérisé en ce que** la matière première contient au moins un silane de la formule (I) défini comme dans la revendication 1 et au moins un silane de la formule (III) défini comme dans la revendication 4, dans lequel le/les silane(s) de la formule (I) et le/les silane(s) de la formule (III) sont présents dans un rapport molaire de 1:1.

7. Procédé selon l'une quelconque des revendications précédentes, **caractérisé en ce que** la matière première contient au moins un autre composé, sélectionné parmi les alcoxydes C₁-C₈ des métaux du groupe principal III, du germanium et de métaux du sous-groupe II, III, IV, V, VI, VII et VIII.

8. Procédé selon l'une quelconque des revendications précédentes, **caractérisé en ce que** la matière première contient en outre au moins un silane de la formule (IV)
R¹ₐSiR²₄₋ₐ (IV)
dans laquelle R¹ et R² ont la signification indiquée dans la revendication 1 pour la formule (I).

9. Procédé selon l'une quelconque des revendications précédentes, dans lequel R² dans la formule (I) n'est pas présent ou ne porte aucun groupe pouvant être ajouté à une liaison double, **caractérisé en ce que** la matière première contient au moins un autre silane de la formule (V)
R²ₐSiX₄₋ₐ (V)
dans laquelle R² porte un groupe, qui peut être ajouté de façon radicalaire à une liaison double C=C.

10. Procédé selon l'une quelconque des revendications précédentes, **caractérisé en ce que** le matériau présente au moins 0,1 mole d'un groupe accessible à une polymérisation à deux photons, rapportée à la quantité molaire en atomes de silicium plus éventuellement les atomes de métaux du groupe principal III, de germanium et du sous-groupe II, III, IV, V, VI, VII et VIII.

11. Procédé selon l'une quelconque des revendications précédentes, **caractérisé en ce que** l'on solidifie le matériau à solidifier dans le bain selon les données de description de la géométrie du corps moulé à créer, **en ce que** l'on remplit les conditions d'exposition par une concentration d'intensité accrue du rayonnement.

12. Procédé selon la revendication 11, **caractérisé en ce que** l'on envoie un faisceau laser focalisé (8) dans le bain (5), dans lequel les conditions d'exposition pour la solidification du matériau liquide à pâteux ne sont remplies qu'au voisinage immédiat du foyer, et **en ce que** l'on guide le foyer du faisceau vers les endroits en cours de solidification selon les données de description de la géométrie du corps moulé à créer à l'intérieur du volume du bain.

13. Procédé selon l'une des revendications 11 ou 12, **caractérisé en ce que** l'on expose le matériau à solidifier dans le bain à un laser (1), qui émet des impulsions de rayonnement de faible durée d'impulsion et de haute puissance de rayonnement par impulsion, en particulier avec un laser femtoseconde.

14. Procédé selon la revendication 13, **caractérisé en ce que** le laser femtoseconde est un laser à modes couplés, en particulier un laser titane-saphir.

15. Procédé selon l'une quelconque des revendications 12 à 14, **caractérisé en ce que** l'on guide le foyer du faisceau laser selon une ou plusieurs des mesures suivantes vers les endroits à solidifier à l'intérieur du bain:
- on déplace de façon commandée par rapport au bain (5) des éléments optiques (4) destinés à la focalisation du faisceau;
- on déplace de façon commandée par rapport au bain (5) des éléments optiques de déviation de faisceau (3) destinés à la déviation du faisceau;
- on déplace de façon commandée par rapport au foyer du faisceau un récipient contenant le bain;
- on déplace dans le bain de façon commandée par rapport au foyer du faisceau une plate-forme de construction présente à l'intérieur d'un récipient contenant le bain.

16. Procédé selon l'une quelconque des revendications précédentes, **caractérisé en ce que** la ou une des surfaces du corps moulé à créer doit présenter des structures de l'ordre de grandeur de moins de 10 µm, de plus grande préférence de moins de 1 µm et de la plus grande préférence de moins de 0,1 µm.

17. Procédé selon l'une quelconque des revendications 1 à 16, **caractérisé en ce qu'**il est constitué par un procédé de prototypage rapide.

18. Procédé selon l'une quelconque des revendications 1 à 16, **caractérisé en ce que** l'on obtient différents dégrés de réticulation à l'intérieur du corps moulé, du fait que l'exposition est effectuée avec différents gradients d'intensité, de préférence en faisant baisser l'intensité et en élargissant le foyer.

19. Procédé selon l'une quelconque des revendications 1 à 18, **caractérisé en ce que** le corps moulé tridimensionnel autoporteur et/ou porté par un support est une structure optiquement active ou passive, un cristal photonique ou une optique de diffraction.

20. Procédé selon l'une quelconque des revendications 1 à 18, **caractérisé en ce que** le corps moulé tridimensionnel autoporteur et/ou porté par un support est un corps moulé diélectrique, une partie d'un composant avec utilisation d'un diélectrique ou une partie d'un corps moulé magnétique.

21. Procédé selon l'une quelconque des revendications 1 à 18, **caractérisé en ce que** le corps moulé tridimensionnel autoporteur et/ou porté par un support présente la forme d'une biopuce ou d'un système micro-électromécanique (MEMS) ou d'un MEMS optique ou présente la forme d'un élément de structure d'une biopuce ou d'un MEMS ou d'un MEMS optique.

22. Procédé selon l'une quelconque des revendications 1 à 18, dans lequel le corps moulé tridimensionnel autoporteur et/ou porté par un support présente la configuration d'un masque lithographique ou d'un masque de gaufrage.

23. Procédé selon l'une quelconque des revendications 1 à 18, **caractérisé en ce que** le corps moulé tridimensionnel autoporteur et/ou porté par un support présente la configuration d'un implant médical, en particulier pour la région des oreilles ou du coeur.

24. Procédé selon la revendication 23, **caractérisé en ce que** le corps moulé présente la configuration d'un implant cochléaire ou d'une valve cardiaque.

25. Procédé selon l'une quelconque des revendications 1 à 18, **caractérisé en ce que** le corps moulé tridimensionnel autoporteur et/ou porté par un support présente la configuration d'un capteur à micro-puce, de préférence d'un détecteur de gaz, dans lequel de préférence des groupes N-H sont intégrés dans le polysiloxane organiquement modifié.

26. Procédé selon l'une quelconque des revendications 1 à 18, **caractérisé en ce que** le corps moulé tridimensionnel autoporteur et/ou porté par un support ou la structure de surface présente des nids d'abeilles ou des canaux, dans lequel le rapport de forme entre la profondeur des canaux ou des nids d'abeilles et la largeur des parois entre les canaux ou les nids d'abeilles peut atteindre 500.
